# EUROPEAN PATENT APPLICATION

(11) **EP 4 711 278 A1**
(43) Date of publication of application: **18.03.2026**
(21) Application number: 24803322.7
(22) Date of filing: 10.04.2024
(51) Int. Cl.: B64D 27/24, B64F 5/40, B64U 50/37, H02J 7/10

(54) **CONTROL DEVICE, CONTROL METHOD, AND CONTROL PROGRAM**

(30) Priority: 10.05.2023 JP 2023077927
(71) Applicant: DENSO CORPORATION, Kariya-city, Aichi 448-8661 (JP)
(72) Inventor: NAKAMURA, Masaya, Kariya-city, Aichi 448-8661 (JP); YOSHIDA, Shuhei, Kariya-city, Aichi 448-8661 (JP)
(74) Representative: TBK
(86) International application number: PCT/JP2024/014487
(87) International publication number: WO 2024/232207

(57) **Abstract**

A controller (40) controls charging of a battery (14) mounted on an eVTOL (10). The controller includes an acquisition unit (41) and a setting unit (42). The acquisition unit acquires a battery load profile and/or a battery state profile as a profile during landing flight. The setting unit sets a charging plan for when the eVTOL is parked based on the profile before completion of battery transient change after landing.

## Description

### CROSS REFERENCE TO RELATED APPLICATION

The present application is based on and claims the benefit of priority from Japanese Patent Application No. 2023-077927 filed on May 10, 2023, the entire disclosure of the above application is incorporated herein by reference.

### TECHNICAL FIELD

The disclosure in this specification relates to a controller, a control method, and a control program for controlling charging of a battery of an electric flight vehicle.

### BACKGROUND

Patent Literature 1 discloses a mobility service system that uses an electric vertical take-off and landing aircraft. The disclosure of Patent Literature is incorporated herein by reference to explain technical elements described herein.

### PRIOR ART LITERATURE

### PATENT LITERATURE

Patent Literature 1: JP 2022-070119 A

### SUMMARY OF INVENTION

In Patent Literature 1, in order to increase opportunities for mobility services, available electric vertical take-off and landing aircrafts are identified and the charge amount of at the start of flight is estimated. Then, if the charge amount is sufficient to reach the destination, an itinerary for the flight to the destination is created. If the charge amount is insufficient, an itinerary for the flight via a relay point is created.

By the way, in the commercial use of electric flight vehicle, such as electric vertical take-off and landing aircraft, achieving a high utilization rate is important, and, particularly, ground operations that require time for charging are crucial. However, rapid charging of the battery after the electric flight vehicle lands may accelerate battery deterioration. There is also a risk of excessive temperature rise or other abnormalities occurring. In the above viewpoint and other viewpoints that are not mentioned, further improvements are awaited for a controller, a control method, and a control program.

One disclosed object is to provide a controller, a control method, and a control program that are capable of increasing an operating rate while reducing battery deterioration and malfunction.

One aspect of the disclosure is a controller for controlling charging of a battery mounted on an electric flight vehicle. The controller includes an acquisition unit and a setting unit. The acquisition unit is configured to acquire a battery profile. The battery profile includes a battery load profile during landing flight and/or a battery state profile during landing flight. The setting unit is configured to set a charging plan based on the battery profile before completion of a transient change of the battery after landing. The charging plan is a plan of charging during parking of the vehicle.

Through diligent investigation, it was found that there is a high correlation between the stable battery state after a certain period has elapsed since landing and the above-described profile. Furthermore, it was found that, based on the profile, a plan can be established to charge as rapidly as possible without waiting for stabilization, in a way that does not cause battery deterioration or malfunction. The disclosed controller is based on this finding. The controller acquires the profile during landing flight, and sets the charging plan for when the aircraft is parked, based on the profile before the battery transient changes are completed after landing, i.e., before the battery state stabilizes. This makes it possible to start rapid charging as soon as possible after landing, while reducing the risk of battery deterioration or malfunction. Therefore, it is possible to provide a controller that is capable of increasing the operating rate of the electric flight vehicle while suppressing battery deterioration and malfunction.

Another aspect of the disclosure is a control method executed by a processor for controlling charging of a battery mounted on an electric flight vehicle. In the method, a battery profile is acquired. The battery profile includes a battery load profile during landing flight and/or a battery state profile during landing flight. A charging plan is set based on the battery profile before completion of a transient change of the battery after landing, the charging plan being a plan of charging during parking of the vehicle.

The disclosed control method is based on the above findings. The control method includes obtaining the profile during landing flight and setting a charging plan for when the aircraft is parked based on the profile before battery transient changes are completed after landing, i.e., before the battery condition stabilizes. This makes it possible to start rapid charging as soon as possible after landing, while reducing the risk of battery deterioration or malfunction. Therefore, it is possible to provide a control method that is capable of increasing the operating rate of the electric flight vehicle while suppressing battery deterioration and malfunction.

Another aspect of the disclosure is a control program stored in a storage medium for controlling charging of a battery mounted on an electric flight vehicle. The control program includes instructions configured, when executed by a processor, to cause the processor to carry out acquiring a battery profile and setting a charging plan based on the battery profile before completion of a transient change of the battery after landing. The battery profile includes a battery load profile during landing flight and/or a battery state profile during landing flight. The charging plan is a plan of charging during parking of the vehicle.

The disclosed control program of this embodiment is based on the above findings. The control program includes instructions for obtaining the profile during landing flight and setting the charging plan for when the aircraft is parked based on the profile before battery transient changes are completed after landing, i.e., before the battery condition stabilizes. This makes it possible to start rapid charging as soon as possible after landing, while reducing the risk of battery deterioration or malfunction. Therefore, it is possible to provide a control program that is capable of increasing the operating rate of the electric flight vehicle while suppressing battery deterioration and malfunction.

The disclosed aspects in this specification adopt different technical solutions from each other in order to achieve their respective objectives. The reference signs in parentheses described in the claims and this section are provided for illustrative purposes to indicate correspondence with parts of the embodiments described later, and are not intended to limit the technical scope. The objects, features, and advantages disclosed in this specification will become apparent by referring to following detailed descriptions and accompanying drawings.

### BRIEF DESCRIPTION OF DRAWINGS

FIG. 1 is a diagram a configuration of an eVTOL and a ground station.
FIG. 2 is a diagram illustrating a power profile.
FIG. 3 is a diagram illustrating a controller and a control system according to a first embodiment.
FIG. 4 is a flowchart illustrating a control process.
FIG. 5 is a flowchart illustrating a charging plan setting process.
FIG. 6 is a flowchart illustrating a charging plan setting process according to a second embodiment.
FIG. 7 is a diagram illustrating an example of a change in degree of temporary deterioration due to flight and charging after the flight.
FIG. 8 is a flowchart illustrating a charging plan setting process according to a third embodiment.
FIG. 9 is a flowchart illustrating a charging plan setting process according to a fourth embodiment.

### EMBODIMENTS FOR CARRYING OUT INVENTION

Hereinafter, several embodiments will be described with reference to the drawings. The same or corresponding elements in the embodiments are assigned the same reference numerals, and redundant descriptions thereof may be omitted. When only a part of the configuration is described in one embodiment, the other parts of the configuration may employ descriptions about a corresponding configuration in another embodiment preceding the one embodiment. Further, not only the combinations of the configurations explicitly shown in the description of the respective embodiments, but also the configurations of multiple embodiments can be partially combined even when they are not explicitly shown as long as there is no difficulty in the combination in particular.

A cooling device and cooling system described below are applied to an electric flight vehicle. The description of A and/or B means at least one of A and B. That is, the A and/or B can include only A, only B, and both A and B.

### First Embodiment

An electric flight vehicle includes a motor (rotating electrical machine) as a drive source for movement. The electric flight vehicle may be referred to as an electric airplane, an electric aircraft, or the like. The electric flight vehicle can move vertically and horizontally. The electric flight vehicle is capable of moving in a direction that has both vertical and horizontal components, in other words, in an oblique direction. The electric flight vehicle includes, for example, electric vertical takeoff and landing aircraft (eVTOL), electric short takeoff and landing aircraft (eSTOL), drones, etc. eVTOL is an abbreviation for electric Vertical Take-Off and Landing aircraft. eSTOL is an abbreviation for electronic Short distance Take-Off and Landing aircraft.

The electric flight vehicle may be either a manned vehicle or an unmanned vehicle. In the case of a manned vehicle, the electric flight vehicle is operated by a pilot as an operator. In the case of an unmanned vehicle, the electric flight vehicle can be controlled remotely by an operator or automatically by a control system. As an example, the electric flight vehicle in this embodiment is an eVTOL.

### (eVTOL)

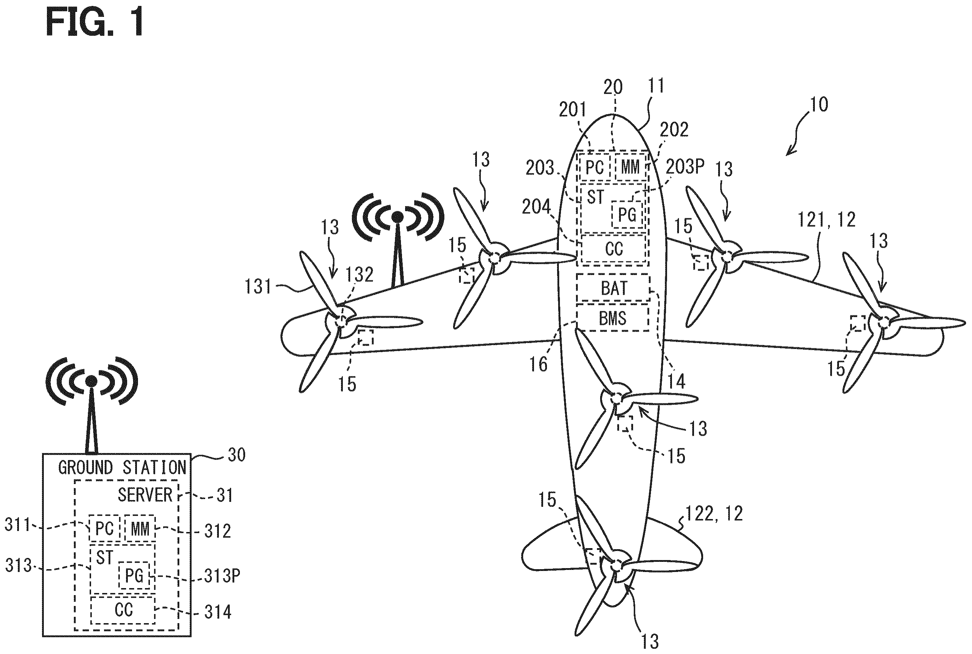

FIG. 1 shows the eVTOL and a ground station. As shown in FIG. 1, the eVTOL 10 includes an aircraft body 11, fixed wings 12, rotary wings 13, a battery 14, EPUs 15 and BMS 16.

The aircraft body 11 is the fuselage of the aircraft. The aircraft body 11 has a shape that extends in the front-rear direction. The aircraft body 11 defines a cabin for an occupant and/or a cargo hold for carrying luggage.

The fixed wings 12 are wings of the aircraft and connected to the aircraft body 11. The fixed wings 12 provide gliding lift. The gliding lift is the lift generated by the fixed wings 12. The fixed wings 12 may include a main wing 121 and a tail wing 122. The main wing 121 extends to the left and right from near the center of the aircraft body 11 along the front-rear direction. The tail wing 122 extends to the left and right from the rear of the aircraft body 11. The shape of the fixed wings 12 is not particularly limited. For example, swept-back wings, delta wings, straight wings may be used.

The rotary wings 13 are provided on the aircraft. At least one of the rotary wings 13 may be provided on the fixed wings 12. At least one of the rotary wings 13 may be provided on the aircraft body 11. The number of the rotary wings 13 provided on the eVTOL 10 is not particularly limited. Multiple rotary wings 13 may be provided on both the aircraft body 11 and the main wing 121.

The rotary wings 13 may be referred to as a rotor, propeller, or fan. The rotary wings 13 each have blades 131 and a shaft 132. The blades 131 are attached to the shaft 132. The blades 131 are vanes that rotate together with the shaft 132. Multiple blades 131 extend radially around the axis of the shaft 132. The shaft 132 is a rotation axis of a rotary wing 13 and is rotated by a motor of an EPU 15.

The rotary wings 13 generate thrust through rotation. The thrust primarily acts as rotational lift on the eVTOL 10 during takeoff and landing operations. The rotary wings 13 primarily provide rotational lift during takeoff and landing operations. The rotational lift is the lift generated by the rotation of the rotary wings 13. During takeoff and landing operations, the rotary wings 13 may provide only rotational lift, or may provide both rotational lift and forward thrust. The rotary wings 13 provide rotational lift during the hovering of the eVTOL 10.

The thrust primarily acts as propulsive force on the eVTOL 10 during cruising operations. The rotary wings 13 primarily provide thrust during cruising operations. During cruising operations, the rotary wings 13 may provide only thrust or may provide both lift and thrust.

The battery (BAT) 14 is a device for driving the rotary wings 13. The battery 14 is sometimes referred to as a battery pack. The battery 14 is capable of storing direct current power and includes chargeable battery cells. The battery 14 includes at least one battery module having multiple battery cells. Each battery cell is a secondary battery that generates electromotive force through chemical reactions. Each battery cell is, for example, a lithium-ion secondary battery, a nickel-metal hydride secondary battery, or the like. Each battery cell may be a secondary battery in which an electrolyte is a liquid, or may be what is called an all-solid-state battery in which an electrolyte is a solid. Each battery cell may have any configuration as long as the battery reaction occurs by ions (electrolyte) contributing to the battery reaction moving between positive and negative electrodes via an electrolytic solution and/or a solid electrolyte. The eVTOL 10 may include a fuel cell and a generator in addition to the battery 14 as a power source that supplies power to the equipment. The battery 14 supplies electric power to the EPUs 15. The battery 14 may supply power to auxiliary machinery (not shown) such as an air conditioner, an ECU 20 (described later), a lift adjustment mechanism (not shown), and the like.

The battery 14 of the eVTOL 10 is required to have high capacity and high output performance. For this reason, battery cells that can obtain high capacity and high output are preferable. In terms of output, battery cells having low resistance in a wide SOC region are preferable. In particular, battery cells having low resistance and high output even in a low SOC region are preferable. SOC is an abbreviation for State Of Charge.

A positive electrode material for the battery cells may be, for example, LCO, NMC, NCA, LFP, or LMFP. LCO is lithium cobalt oxide (LiCoO₂). NMC is a lithium nickel cobalt manganese oxide (Li(NiMnCo)O₂). NCA is lithium nickel cobalt aluminate (Li(NiCoAl)O₂). LFP is lithium iron phosphate (LiFePO₄). LMFP is lithium manganese iron phosphate (LiFeₓMn_{y}PO₄). In particular, a positive electrode of LMFP or a cathode obtained by blending LMFP and NMC, which have low resistance in the low SOC region is preferable.

A negative electrode material for the battery cells may be, for example, a carbon-based material such as hard carbon or soft carbon, a silicon-based material, a lithium-based material, or a titanium-based material such as LTO or NTO. LTO is lithium titanate (Li₄Ti₅O₁₂). NTO is niobium titanium oxide (TiNb₂O₇). In particular, a negative electrode of a carbon-based material or a negative electrode of a titanium-based material, which has low resistance in the low SOC region, is preferable.

The EPUs 15 rotate and drive the rotary wings 13 that provide thrust to the eVTOL 10. The EPUs 15 are equipment for rotationally driving the rotary wings 13. EPU is an abbreviation for Electric Propulsion Unit. Each EPU 15 corresponds to an electric propulsion device. Each EPU 15 is equipped with a motor. Each EPU 15 includes an inverter and an ESC in addition to the motor. ESC is an abbreviation for Electronic Speed Controller. As an example, the number of the EPUs 15 is the same as the number of the rotary wings 13. In other words, the eVTOL 10 has six EPUs 15. The EPUs 15 and the rotary wings 13 are connected in a one-to-one relationship. Alternatively, two or more rotary wings 13 may be connected to a single EPU 15 via a gear box.

The BMS 16 monitors the state of the unit batteries that constitute the battery 14. BMS is an abbreviation for Battery Management System. The BMS 16 is capable of monitoring the voltage, current, temperature, internal resistance, SOC, SOH, and other safety-related states of the battery 14, such as the internal pressure and gas leakage. SOH is an abbreviation for State Of Health. The BMS 16 may be provided integrally with the battery 14. A part of the BMS 16 may be provided integrally with the battery 14, and another part of the BMS 16 may be provided separately from the battery 14.

The eVTOL 10 further includes an ECU 20 and an auxiliary machine (not shown). ECU is an abbreviation for Electronic Control Unit. The eVTOL 10 may include a lift adjustment mechanism (not shown). The lift adjustment mechanism adjusts the gliding lift of the fixed wings 12. The lift adjustment mechanism increases or decreases the gliding lift generated by the fixed wings 12. The eVTOL 10 may be equipped with, for example, a tilt mechanism or flaps as the lift adjustment mechanism. The tilt mechanism is driven to adjust the tilt angle of the rotary wings 13. The flaps are movable wing pieces and provided on the fixed wings 12.

### (Operation Management Device)

The operation management device is a device for creating an operation plan of the aircraft, monitoring an operation status of the aircraft, collecting and managing information related to an operation of the aircraft, supporting the operation of the aircraft, and the like. At least a part of functions of the operation management device may be arranged in an internal computer of the eVTOL 10. At least a part of the functions of the operation management device may be arranged in an external computer that can wirelessly communicate with the eVTOL 10. An example of the external computer is a server 31 of a ground station 30 illustrated in FIG. 1. The ground station 30 can wirelessly communicate with the eVTOL 10. The ground station 30 can wirelessly communicate with other ground stations.

As an example, in the present embodiment, a part of the functions of the operation management device is arranged in the ECU 20 of the eVTOL 10, and a part of the functions of the operation management device is provided in the server 31 of the ground station 30. The functions of the operation management device are shared between the ECU 20 and the server 31. The operation management device includes an internal management unit and an external management unit.

As shown in FIG. 1, the ECU 20 includes a processor (PC) 201, a memory (MM) 202, a storage (ST) 203, and a communication circuit (CC) 204 for wireless communication. The processor 201 executes various processes by accessing the memory 202. The memory 202 is a rewritable volatile storage medium. The memory 202 is, for example, a RAM. RAM is an abbreviation for Random Access Memory. The storage 203 is a rewritable nonvolatile storage medium. The storage 203 stores a program (PG) 203P to be executed by the processor 201. The program 203P constructs multiple functional units by causing the processor 201 to execute multiple instructions. The ECU 20 may include multiple processors 201.

Similar to the ECU 20, the server 31 includes a processor (PC) 311, a memory (MM) 312, a storage (ST) 313, and a communication circuit (CC) 314. The processor 311 executes various processes by accessing the memory 312. The memory 312 is a rewritable volatile storage medium, for example, a RAM. The storage 313 is a rewritable nonvolatile storage medium. The storage 313 stores a program (PG) 313P to be executed by the processor 311. The program 313P constructs multiple functional units by causing the processor 311 to execute multiple instructions. The server 31 may include multiple processors 311.

### (Power Profile)

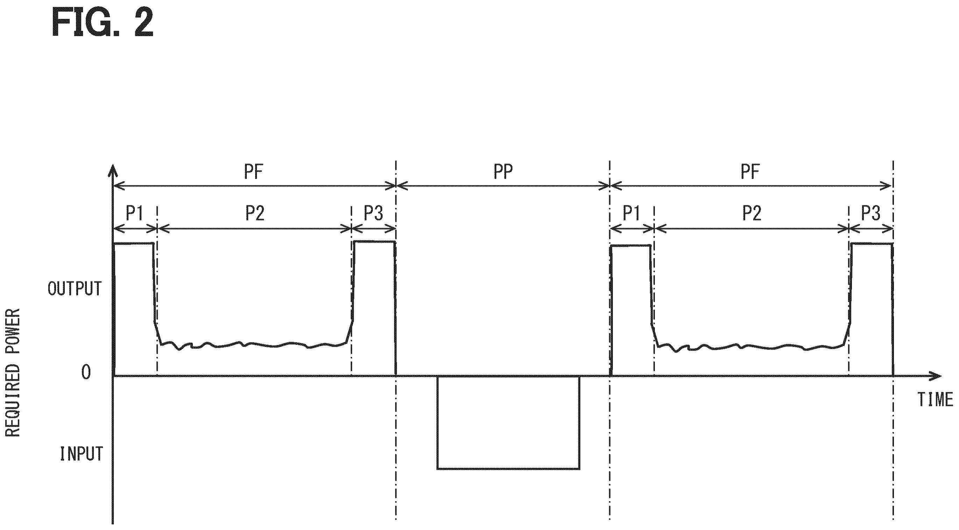

FIG. 2 shows a power profile from take-off to landing of the eVTOL. The power profile of electric flight vehicles other than eVTOL is similar to that of the eVTOL. The period P1 is referred to as takeoff flight time, takeoff operation time, takeoff period, etc. The period P2 is referred to as cruising flight time, cruising operation time, cruising period, etc. The period P3 is referred to as landing flight time, landing operation time, landing period, etc. The periods P1 and P3 are referred to as takeoff and landing operation time, takeoff and landing operation time, takeoff and landing period, etc. For convenience, in FIG. 1, the required power, that is, the output, is kept constant over almost the entire periods P1 and P3, respectively. The period PF is referred to as flight period, flight time, etc. The period PP is referred to as parking period, parking time, etc.

The eVTOL ascends from a take-off point to a cruising start point in the period P1. The eVTOL cruises at a predetermined altitude in the period P2. The eVTOL descends from an end point of the period P2 to a landing point in the period P3. The movement of the eVTOL mainly includes horizontal components during the period P2 and mainly includes vertical components during the periods P1 and P3. During the periods P1 and P3 when moving in the vertical direction, the operation of the rotary wings 13 requires high output continuously for a predetermined time.

In particular, for commercial eVTOLs, it is necessary to minimize the preparation time required between landing and the next takeoff, that is, the period PP shown in FIG. 2, in order to increase the operational rate. For this reason, it is preferable to start rapid charging as soon as possible after landing. However, in eVTOL, due to the high rate of battery load during landing flight, the battery state does not stabilize immediately after landing, and a certain amount of time is required until the battery state stabilizes. If rapid charging is started indiscriminately before the battery stabilizes, it can cause battery deterioration or malfunction. If you wait for the battery to stabilize in order to understand its state and then perform charging suitable for the determined battery state, it is not possible to reduce the preparation time.

Battery load during landing flight varies depending on human and environmental factors. Thus, battery conditions such as battery temperature and SOC vary from flight to flight. Therefore, in order to efficiently perform rapid charging within the limited period PP without causing battery deterioration or malfunction, it is important to understand the battery status for each flight and set an appropriate rapid charging plan in advance, taking into account the load during rapid charging.

In addition, from the landing flight to the completion of landing, the battery load drops rapidly, causing the battery state to undergo a transient change. For example, battery data such as battery temperature and voltage, which are used to calculate the battery state, undergo transient changes. Understanding the battery state using raw data during transient changes may lead to erroneous determination. It is preferable to wait until the transient changes in the battery state are complete and then perform rapid charging based on the stabilized battery state. However, the time required for the battery state to stabilize is long, and in practical operation, it is necessary to perform rapid charging without waiting for stabilization. For example, stabilizing the temperature distribution can take several tens of minutes or more. Furthermore, stabilizing the voltage, for instance during OCV measurement, may take several hours or more. Recovery from temporary deterioration, when simply left alone, can take several days or more. OCV is an abbreviation for Open Circuit Voltage.

Therefore, to enhance the operational rate (utilization rate) while suppressing battery deterioration and malfunction, it is important to predict the battery state at an early stage before the completion of transient changes during each rapid charging session, and to set an appropriate rapid charging plan taking into account the load during rapid charging.

Temporary deterioration refers to a temporary (reversible) increase in the internal resistance of the battery due to an imbalance in ion concentration. For example, when a secondary battery outputs, or discharges, a temporary imbalance occurs in the concentration distribution of ions that contribute to the battery reaction. The concentration imbalance occurs in the electrolytic solution or the electrode. When the concentration imbalance occurs, the internal resistance of the battery temporarily (reversibly) rises. Therefore, even when the SOC of the battery is sufficient, the output performance of the battery decreases. The temporary deterioration may be referred to as high-rate deterioration.

### (Controller)

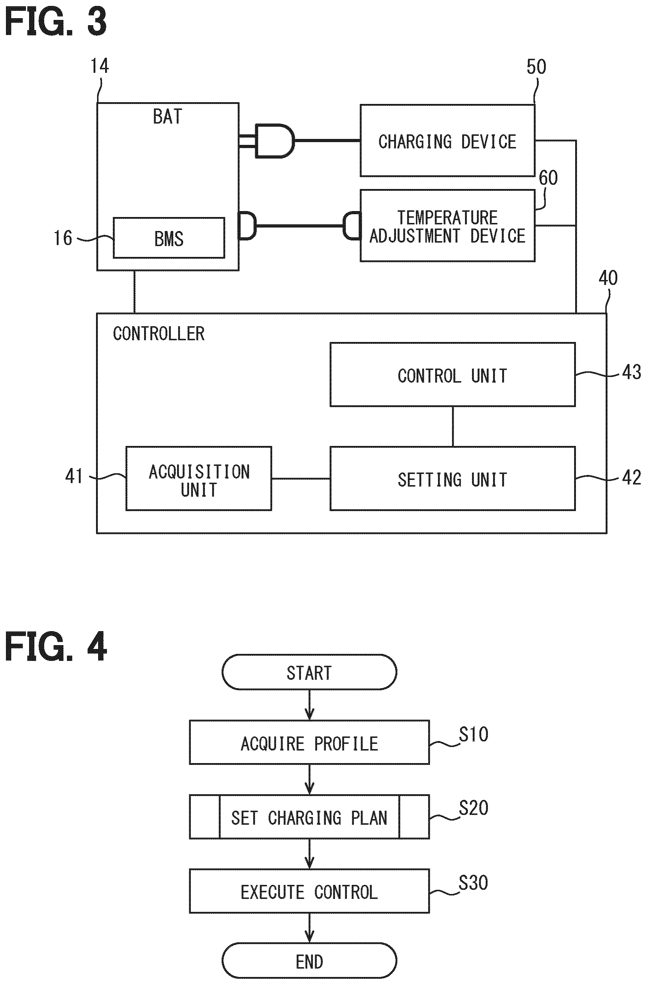

FIG. 3 shows a controller for controlling the charging of the battery 14. FIG. 3 shows a system including the controller.

The controller 40 controls processing relating to the battery 14. The controller 40 controls, for example, the charging of the battery 14. The controller 40 may control not only charging but also discharging. That is, charging and discharging may be controlled. The controller 40 controls the battery-related processing. The controller 40, together with a charging device 50 and a temperature adjustment device 60, constitutes the control system. The charging device 50 charges the battery 14 according to instructions from the controller 40. The charging device 50 may charge and discharge the battery 14 according to instructions from the controller 40. When the charging device 50 has a discharging function, it may be referred to as a charging/discharging device. The temperature adjustment device 60 adjusts the temperature of the battery 14 according to instructions from the controller 40.

The controller 40 controls charging while the aircraft is parked. The controller 40 may control charging not only when the aircraft is parked, but also when the aircraft is in flight. The controller 40 may execute control over discharging of the battery 14 during flight, i.e., flight-related control.

The functional arrangement of the controller 40 is not particularly limited. At least a part of the functions of the controller 40 may be located outside the aircraft or onboard the aircraft. Some of the functions of the controller 40 may be located outside the aircraft, and other parts of the functions may be located onboard the aircraft. At least a part of the functions of the controller 40 may be located in the server 31 of the ground station 30. The program 313P constructs functional units of the controller 40 by causing the processor 311 to execute multiple instructions. At least a part of the functions of the controller 40 may be located in the ECU 20. The program 203P constructs functional units of the controller 40 by causing the processor 201 to execute multiple instructions.

At least a part of the functions of the controller 40 may be located within the operation management device. At least a part of the functions of the controller 40 may be located in the charging device 50 or in the temperature adjustment device 60. At least a part of the functions of the controller 40 may be located in the BMS 16. In this manner, the controller 40 may be integrated with other devices.

The charging device 50 is an external power source separate from the battery 14 and/or a power converter that converts power supplied from an external power source. The charging device 50 may be disposed outside the aircraft or inside the aircraft. A part of the charging device 50 may be disposed outside the aircraft, and another part of the charging device 50 may be disposed inside the aircraft. In either case, the battery 14 can be charged while the aircraft is parked. The battery 14 may be charged during flight by the charging device 50 located onboard the aircraft, such as a generator or a power converter that converts regenerative power.

The temperature adjustment device 60 is a device that adjusts the temperature of the battery 14. The temperature adjustment device 60 may have a function of cooling the battery 14. The temperature adjustment device 60 may have a function of warming the battery 14, for example, a function of keeping the battery 14 warm. The temperature adjustment device 60 may have both the function of cooling and the function of warming the battery 14. The temperature adjustment device 60 may be a device that utilizes sensible heat of a fluid. The fluid may be any suitable fluid, such as a gas or a liquid. For example, water, coolant water to which LLC has been added, refrigerant, oil, air, etc. may be used. LLC is an abbreviation for long life coolant. The temperature adjustment device 60 may be disposed outside the aircraft or inside the aircraft. A part of the temperature adjustment device 60 may be disposed outside the aircraft, and another part of the temperature adjustment device 60 may be disposed inside the aircraft. The temperature adjustment device 60 may include a heat exchanger, a pump, piping, etc., which are not shown. The temperature adjustment device 60 may include an air conditioner. The temperature adjustment device 60 may include a heating means such as a heater. The temperature adjustment device 60 may include multiple devices capable of individually adjusting the battery temperature.

As shown in FIG. 3, the controller 40 includes an acquisition unit 41 and a setting unit 42. The acquisition unit 41 acquires a profile during landing flight. The acquisition unit 41 may acquire a profile after landing and before the completion of the battery transient change, instead of or in addition to the profile during landing flight. The acquisition unit 41 acquires a battery load profile and/or a battery state profile as a profile. The acquisition unit 41 acquires the profile from the BMS 16, an operation management device, etc.

The acquisition unit 41 may acquire, as the profile, actual measured values of the profile or intermediate calculated values. The acquisition unit 41 may acquire, as the profile, a calculated value of the profile feature quantity. The acquisition unit 41 may acquire the profile by performing calculations based on actual measurement values and intermediate calculation values acquired from the BMS 16, an operation management device, etc. The acquisition unit 41 may also acquire other information, such as flight information and weather information, from an operation management device or the like. The acquisition unit 41 acquires information such as the profile through wireless communication and/or wired communication.

The setting unit 42 sets the charging plan for when the aircraft is parked, before the transient changes of the battery after landing is completed, based on the profile acquired by the acquisition unit 41. The charging plan may include a forced cooling plan. The setting unit 42 predicts the battery state early based on the profile, and detects signs of battery abnormality from the prediction result. The setting unit 42 determines whether to perform a necessary process in relation to charging during parking, based on the presence or absence of signs of battery abnormalities, and sets the charging plan based on the determination result. Hereinafter, the necessary process to be performed in relation to charging during parking may be simply referred to as necessary process.

The setting unit 42 may determine whether to perform a process to adjust temperature of the battery 14 and/or a process to change charging conditions as the necessary process, and set the charging plan based on the determination result. The setting unit 42 may predict the maximum temperature Tmax of the battery 14 during charging as the battery state, and detect a sign of an abnormality of excessive temperature rise of the battery 14 during charging based on this prediction result. The setting unit 42 may determine, based on the prediction of the maximum temperature Tmax, whether to perform forced cooling of the battery 14 before the start of charging and/or limit the charging power at the start of charging as the necessary process. The setting unit 42 may predict the maximum temperature Tmax under a condition of the minimum charging power among the charging conditions that satisfy the required charging capacity and the operation plan of the aircraft.

The controller 40 may further include a control unit 43. The control unit 43 executes control in accordance with the charging plan set by the setting unit 42. The controller 40 controls the operation of the charging device 50 and/or the temperature adjustment device 60. The controller 40 includes at least the acquisition unit 41 and the setting unit 42. The functions of the control unit 43 may be provided in a device separate from the controller 40, for example, in an operation management device.

### (Control Method)

As mentioned above, the controller 40 may be located in the server 31 of the ground station 30. In this case, execution of processing of each functional block of the controller 40 by the processor 311 corresponds to execution of a control method. The controller 40 may be disposed in the ECU 20 onboard the aircraft. In this case, execution of processing of each functional block of the controller 40 by the processor 201 corresponds to execution of the control method. As described above, the controller 40 executes the charging control.

FIG. 4 shows an example of a control process, that is, the control method, executed by the controller 40 (processor). First, the controller 40 acquires a profile during landing flight (step S10). The controller 40 acquires a battery load profile and/or a battery state profile as the profile during landing flight.

Next, the controller 40 sets a charging plan for when the aircraft is parked based on the acquired profile (step S20). Next, the controller 40 executes control according to the set charging plan (step S30). The controller 40 controls the operation of the charging device 50 and/or the temperature adjustment device 60 in accordance with the charging plan, and ends the series of processes.

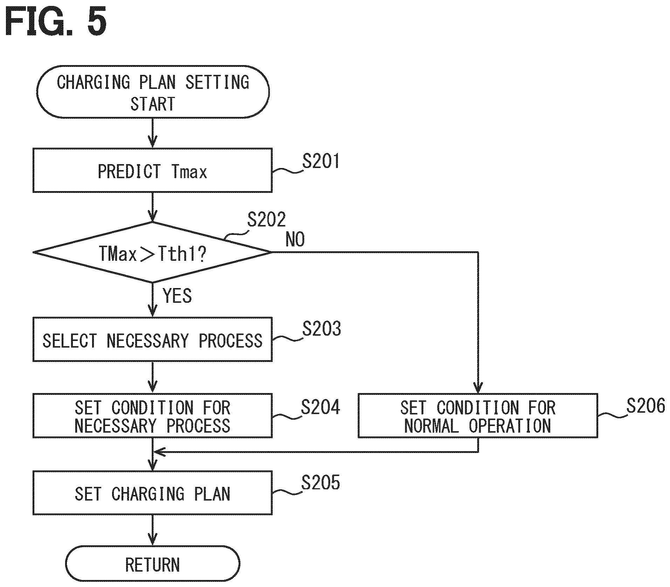

The process of step S20, that is, the charging plan setting method may be the method shown in FIG. 5. First, the controller 40 predicts the maximum temperature Tmax during charging based on the profile acquired in step S10 (step S201).

The controller 40 may predict the battery temperature at the start of charging (start temperature) based on the profile during landing flight, and predict the maximum temperature Tmax based on the predicted start temperature and the charging conditions. The controller 40 predicts the start temperature based on the power load profile of the battery 14 during landing flight and/or the battery temperature variation profile during landing flight. The power load profile is sometimes referred to as the output (discharge) profile. The controller 40 predicts the maximum temperature Tmax based on the start temperature and the power profile that is a charging condition during charging. The power profile, which is the charging condition, may be referred to as an input (charging) profile, a current profile, or the like. The controller 40 may predict the start temperature and the maximum temperature consecutively, or may predict them with a predetermined time interval therebetween.

The controller 40 may directly predict the maximum temperature Tmax based on the power load profile of the battery 14 during landing flight and/or the battery temperature variation profile during landing flight and the power profile that is the charging condition.

The controller 40 may predict the maximum temperature Tmax using the power load profile of the battery 14 during landing flight, as described above. The start temperature may be predicted using a map model or a regression model that associates the profile itself or a feature quantity obtained from the profile with the battery temperature at the start of charging. The feature quantity may be, for example, landing flight time, average or maximum power, power deviation, or a combination thereof. Machine learning can be used to efficiently build feature quantities and models. Alternatively, a thermal analysis simulation model may be used, in which the profile itself or feature quantities are input to derive the start temperature. The start temperature can be predicted with greater accuracy.

The controller 40 may predict the maximum temperature Tmax based on the start temperature and the charging conditions in a similar manner to that used for predicting the start temperature. That is, a map model, a regression model, a thermal analysis simulation model, or the like that associates the starting temperature, the charging conditions, and the battery temperature during charging may be used.

The controller 40 may directly predict the maximum temperature Tmax in a similar manner to the prediction of the start temperature. In other words, the profile itself, feature quantities obtained from the profile, a map model or regression model that associates the charging conditions with the battery temperature during charging, a thermal analysis simulation model, or the like may be used.

When predicting the maximum temperature Tmax using the power load profile during landing flight, it is necessary to obtain information on the absolute value of the battery temperature at any timing in the profile. The absolute value of the battery temperature may be an actually measured value or an estimated value.

The training data required for the above-mentioned modeling and various parameters required for the thermal analysis simulation may be extracted from prior experiments, flight history, etc. When predicting the start temperature, it is preferable to construct a model that allows the battery temperature to be predicted even if the charge start point is changed. Input information (explanatory variables) to the model may include the environmental temperature, battery resistance that affects Joule heat generation, battery heat capacity that affects heat capacity, and heat dissipation characteristics. The prediction can be made more accurate. Information for the prediction may include a power load profile of the battery 14 prior to landing flight.

As described above, the controller 40 may predict the maximum temperature Tmax using the battery temperature variation profile during landing flight. The start temperature may be predicted using a map model or a regression model that associates the profile itself or a feature quantity obtained from the profile with the start temperature. The characteristic quantity is a maximum reached temperature, a temperature at a specific time, a temperature fluctuation rate at a specific time, a maximum temperature fluctuation rate, or a combination thereof. The battery temperature variation profile may include intermediate information on transient changes after landing. In this case, it becomes possible to reflect the transition state of the temperature drop, and the prediction can be made with high accuracy.

The training data required for the above-mentioned modeling may be extracted from prior experiments, flight history, etc. Input information (explanatory variables) to the model may include the environmental temperature, battery resistance that affects Joule heat generation, battery heat capacity that affects heat capacity, and heat dissipation characteristics. The prediction can be made more accurate. It is preferable to construct a model that allows the battery temperature to be predicted even if the charge start point is changed.

After predicting the maximum temperature Tmax, the controller 40 then compares the maximum temperature Tmax with a threshold Tth1 to determine whether the maximum temperature Tmax is greater than the threshold Tth1 (step S202). When Tmax is greater than Tth1, the controller 40 determines that there is a sign of an excessive temperature rise abnormality in the battery 14 due to charging. That is, the sign of the abnormality in the excessive temperature rise of the battery 14 is detected. When Tmax is lower than or equal to Tth1, the controller 40 determines that there is no sign of an excessive temperature rise abnormality.

The process in step S202 is a process for determining whether to perform a necessary process based on the prediction result of the maximum temperature Tmax. When the predicted maximum temperature Tmax exceeds the threshold Tth1, a process for suppressing an increase in battery temperature is determined to be necessary, such as forced cooling of the battery before charging and/or limitation on the charging power at the start of charging. The threshold Tth1 may be an allowable upper limit temperature of the battery 14, or may be an allowable upper limit temperature with an added margin. The margin may be set taking into consideration a prediction error of the maximum temperature Tmax, a control error of the charging equipment, and various errors due to the operation. The margin may be set in consideration of suppressing battery deterioration. The margin may be set in stages based on the state of health (SOH) of the battery 14.

When Tmax is greater than Tth1, the controller 40 selects a necessary process (step S203). The controller 40 may select the necessary process to prevent an overheating abnormality based on whether forced cooling is possible on the ground and the implementation of forced cooling during normal operation. For example, in a case where forced cooling is performed by the temperature adjustment device 60 during and before charging in normal operation, the controller 40 selects limitation on the charging power at the start of charging as the necessary process. The limitation on the charging power is, for example, a limitation of the charging current. In a case where forced cooling is performed during charging but not before charging in normal operation, the controller 40 selects forced cooling of the battery 14 before the start of charging and/or limitation on the charging power at the start of charging as the necessary process. In a case where forced cooling is not performed during charging in normal operation, the controller 40 selects forced cooling during charging as the necessary process. The controller 40 may select forced cooling during charging as well as forced cooling before charging and/or limiting on the charging power at the start of charging. In a case where forced cooling on the ground is not possible, the controller 40 selects limitation on the charging power at the start of charging.

In a case where forced cooling is performed during charging and/or before charging in normal operation, the controller 40 may predict the maximum temperature Tmax when forced cooling in normal operation is performed. When selecting between forced cooling before charging and limitation on the charging power at the start of charging, the time required for processing may be calculated based on the conditions for not exceeding the threshold Tth1, and the method that shortens the calculated time may be selected. The timing of implementing the forced cooling before charging or the limitation on the charging power at the start of charging may be consecutive to the subsequent quick charging or forced cooling. A charge/discharge control pattern, which incorporates forced cooling before charging and limitation on the charging power at the start of charging, may be set.

After the necessary process is selected, the controller 40 then sets the conditions for the necessary process (step S204). The conditions for the forced cooling of the battery 14 before charging and the limitation on the charging power at the start of charging need to satisfy conditions that prevent the battery 14 from overheating even if the battery is subsequently charged under predetermined rapid charging conditions. Therefore, appropriate conditions may be set using a method similar to that used to predict the maximum temperature Tmax. In order to set the appropriate conditions, for example, in a case where forced cooling is performed before charging, and forced cooling is performed during forced charging, predetermined conditions may be set for the forced charging and the forced cooling during charging, while a condition for the forced cooling before charging may be varied. The conditions for the forced cooling before charging include, for example, the battery cooling capacity per unit time, the cooling time, and the like. If the battery cooling capacity is fixed, only the cooling time may be changed.

In order to satisfy the condition that the temperature does not rise excessively even when the battery is rapidly charged, the cooling capacity and the cooling time may be set by a preliminary experiment or may be set by a thermal circuit model or the like. The cooling capacity may be set based on the operation plan of the aircraft using maximum time during which pre-cooling is possible.

In order to set the appropriate conditions, for example, in a case where limitation on charging power at the start of charging is performed and forced charging is performed, a predetermined condition may be set for the forced charging, and a condition for the limitation on the charging power at the start of charging may be varied. The conditions for the limitation on the charging power include a limited power value (limited current value) and a charging time. When cooling the battery 14, the conditions may be appropriately set by adding the conditions for cooling the battery. The forced cooling during the limitation on charging power is more effective and makes it possible to shorten the limiting time. The conditions for the power limitation may be set with a margin. The setting may be made with consideration for suppression of deterioration.

After the conditions are set, the controller 40 then sets a charging plan (step S205). The controller 40 sets profiles for charging/discharging and forced cooling of the battery 14 based on the necessary process and their conditions. When the controller 40 sets the charging plan, the series of processes ends. That is, the process proceeds to step S30.

When Tmax is lower than or equal to Tth1 in step S202, the controller 40 sets conditions for normal operation (step S206), and sets a charging plan based on the set conditions (S205).

### Summary of First Embodiment

Through diligent investigation, it was found that there is a high correlation between the stable battery state after a certain period has elapsed since landing and the profile of the battery 14 during landing flight. Furthermore, it was found that, based on the profile, a plan can be established to charge as rapidly as possible without waiting for stabilization, in a way that does not cause battery deterioration or malfunction.

The controller 40 of the present embodiment is based on this finding. The controller 40 acquires a profile during landing flight, and sets a charging plan for when the aircraft is parked, based on the profile before the battery transient changes are completed after landing, i.e., before the battery state stabilizes. This makes it possible to start rapid charging as soon as possible after landing, while reducing the risk of battery deterioration or malfunction. In other words, it is possible to increase the operational rate of the eVTOL 10 (electric flight vehicle) while suppressing deterioration and malfunction of the battery 14.

The controller 40 may determine whether to perform temperature adjustment of the battery 14 and/or change the charging conditions as the necessary process related to charging during parking. Then, the controller 40 may set a charging plan based on the determination result. Since the necessary process includes the process for the temperature adjustment of the battery 14 and/or the process for changing the charging conditions, it is possible to cover a wide range of abnormality prediction modes of the battery 14. This can reduce the incidence of battery abnormalities.

The controller 40 may determine, based on the prediction of the maximum temperature Tmax of the battery 14 during parking charging, whether to perform forced cooling of the battery 14 before the start of charging and/or limit the charging power at the start of charging the necessary process. This makes it possible to prevent the battery 14 from overheating abnormally even if rapid charging operation is performed following a landing operation, in other words, even if operations with a high output load on the battery 14 are performed consecutively. The forced cooling before charging and power limitation at the start of charging can suppress temperature rise during charging, thereby extending the life of the battery 14. Since excessive temperature rise abnormality is suppressed based on the prediction of the maximum temperature Tmax, it is possible to set appropriate conditions taking efficiency into consideration.

The controller 40 may predict the maximum temperature Tmax under the condition of a minimum charging power among the charging conditions that satisfy the required charging capacity and the operation plan of the aircraft. The maximum temperature Tmax is predicted using conditions that can minimize the temperature rise while still ensuring the required charging capacity and complying with the operation plan of the aircraft. Therefore, an appropriate determination of necessity of the necessary process can be made.

The control method of this embodiment is based on the above findings. The control method is executed by the processor to control the charging of the battery 14. The control method includes obtaining the profile during landing flight and setting a charging plan for when the aircraft is parked based on the profile before battery transient changes are completed after landing, i.e., before the battery condition stabilizes. This makes it possible to start rapid charging as soon as possible after landing, while reducing the risk of battery deterioration or malfunction. In other words, the operational rate of the eVTOL 10 can be increased while suppressing deterioration and malfunction of the battery 14.

The control program of this embodiment is based on the above findings. The control program is stored in the storage medium and includes instructions to be executed by the processor to control charging of the battery 14. The control program includes instructions for obtaining the profile during landing flight and setting the charging plan for when the aircraft is parked based on the profile before battery transient changes are completed after landing, i.e., before the battery condition stabilizes. This makes it possible to start rapid charging as soon as possible after landing, while reducing the risk of battery deterioration or malfunction. In other words, the operational rate of the eVTOL 10 can be increased while suppressing deterioration and malfunction of the battery 14.

### Second Embodiment

This embodiment is a modification based on the preceding embodiment, and the description of the preceding embodiment are incorporated. In the preceding embodiment, the charging plan during parking is set based on the prediction of the maximum temperature Tmax during charging. Alternatively, or additionally, the charging plan during parking may be set based on a prediction of battery temperature just before takeoff.

A controller 40 of the present embodiment includes an acquisition unit 41 and a setting unit 42, similar to the preceding embodiment. The controller 40 may further include a control unit 43. The setting unit 42 sets a charging plan for when the aircraft is parked based on the profile acquired by the acquisition unit 41. The setting unit 42 may predict the battery temperature T0 just before takeoff as the battery state, and based on this prediction result, detect a sign of a low temperature abnormality in the battery 14 before takeoff or a sign of an overheating abnormality during flight. The battery temperature T0 may hereinafter be referred to as pre-takeoff temperature T0. The setting unit 42 may determine whether to perform temperature adjustment of the battery 14 and/or perform adjustment of the charging start timing as a necessary process, based on the prediction of the pre-takeoff temperature T0. The setting unit 42 may predict the pre-takeoff temperature T0 based on the predicted battery temperature at the time of completion of charging, environmental information, and an operation plan of the aircraft.

### (Control Method)

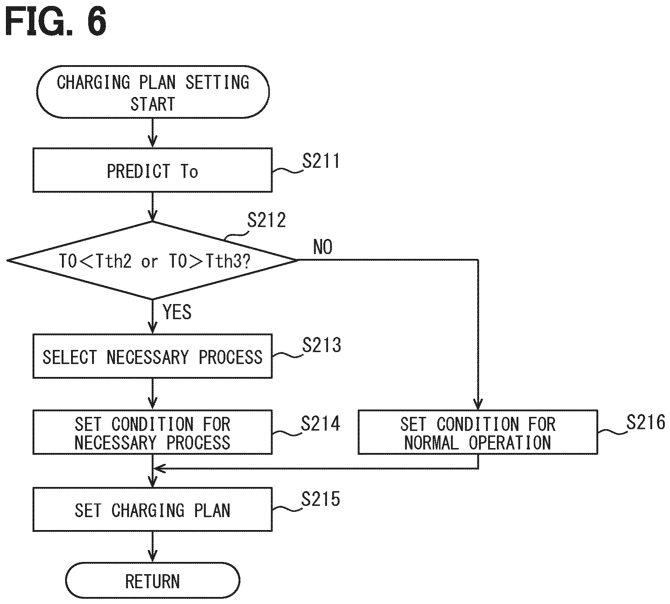

FIG. 6 shows the process of step S20 among the control processes executed by the controller 40 (processor). The processes shown in FIG. 6 correspond to the processes shown in FIG. 5. First, the controller 40 predicts the pre-takeoff temperature T0 of the next flight based on the profile acquired in step S10 (step S211). Step S211 is a process corresponding to step S201.

The controller 40 predicts the start temperature based on the profile during landing flight, and predicts the battery temperature at the completion of charging (end temperature) based on the start temperature and the charging conditions. The pre-takeoff temperature T0 may then be predicted based on the end temperature, environmental information that affects the heat storage or heat dissipation characteristics of the battery 14, and the time from the completion of charging to the start of takeoff (operation plan). The environmental information includes, for example, temperature, wind speed, and wind direction. The start temperature and end temperature can be predicted in the same manner as the start temperature and maximum temperature Tmax described in the preceding embodiment. A map model, a regression model, or the like may be used to predict the pre-takeoff temperature T0. In the period from the completion of charging to the start of takeoff, if there is input or output of the battery 14, such as power supply to auxiliary equipment, input/output conditions may be incorporated as a temperature rise factor in the prediction of the pre-takeoff temperature T0.

The controller 40 may predict the start temperature, the end temperature, and the pre-takeoff temperature T0 consecutively or may predict them at intervals of a predetermined time.

Once the pre-takeoff temperature T0 is predicted, the controller 40 then compares the pre-takeoff temperature T0 with the thresholds Tth2 and Tth3. Then, it is determined whether the pre-takeoff temperature T0 is lower than a threshold Tth2 or whether the pre-takeoff temperature T0 is higher than a threshold Tth3 (step S212). When T0 is lower than Tth2, the controller 40 determines that there is a sign that the battery 14 will experience a low temperature abnormality due to environmental conditions during the period from the completion of charging to the start of takeoff. That is, a sign of a low temperature abnormality in the battery 14 is detected. When T0 is higher than or equal to Tth2, the controller 40 determines that there is no sign of a low temperature abnormality. When T0 is higher than Tth3, the controller 40 determines that there is a sign that the temperature of the battery 14 will become high due to environmental conditions and may experience a high temperature abnormality caused by high-power load of the previous flight during the period from the completion of charging to the start of takeoff. That is, a sign of a high temperature abnormality in the battery 14 is detected. When T0 is lower than or equal to Tth3, the controller 40 determines that there is no sign of a high temperature abnormality.

The process of step S212 is a process for determining whether to perform the necessary process based on the prediction result of the pre-takeoff temperature T0. Step S212 is a process corresponding to step S202. When the predicted pre-takeoff temperature T0 falls below the threshold Tth2, a process for suppressing a drop in battery temperature is determined to be necessary, such as adjustment of the battery temperature and/or adjustment of the charge start timing. When the pre-takeoff temperature T0 exceeds the threshold Tth3, a process for suppressing an increase in the battery temperature is determined to be necessary, such as adjustment of the battery temperature and/or adjustment of the charging start timing.

The threshold Tth2 may be an allowable lower limit temperature of the battery 14, or may be an allowable lower limit temperature with an added margin. The margin may be set taking into consideration a prediction error of the pre-takeoff temperature T0, a control error of the charging equipment, and the like. The threshold Tth3 is a battery temperature threshold before takeoff to prevent a high temperature abnormality from occurring during the next flight, and is set based on the output load profile of the next flight. The threshold Tth3 may also have a margin added thereto, like the other thresholds.

When T0 is lower than Tth2 or T0 is higher than Tth3, the controller 40 selects a necessary process (step S213). Step S213 is a process corresponding to step S203. The controller 40 may select a temperature adjustment process as the necessary process. When T0 is higher than Tth3, the controller 40 may select forced cooling by the temperature adjustment device 60 in order to prevent an abnormality of excessive temperature rise during flight. When T0 is lower than Tth2, the controller 40 may select processing by the temperature adjustment device 60 as a necessary processing in order to prevent a low temperature abnormality before takeoff. The battery 14 may be kept warm by self-heating caused by charging. The controller 40 may select adjustment of the charging start timing as the necessary process.

After the necessary process is selected, the controller 40 then sets the conditions for the necessary process (step S214). Step S214 is a process corresponding to step S204. In the temperature adjustment process, the conditions can be set (derived) in the same manner as in the case of the maximum temperature Tmax. For example, if forced cooling is performed during charging and the battery temperature can be maintained within a range from the threshold Tth2 to the threshold Tth3, then this condition may be continued. If the battery temperature cannot be maintained at a predetermined temperature under forced cooling conditions during charging, the cooling capacity of the temperature adjustment device 60 may be adjusted to maintain the battery temperature within the above-mentioned temperature range.

When the temperature adjustment device 60 is not provided, or when the temperature adjustment device 60 does not have sufficient warming capacity, the battery 14 may be kept warm by its self-heating during charging. The charging conditions for maintaining the battery temperature within the temperature range during warm-keeping charging, such as power and duration, may be derived using the same method as in the preceding embodiment and incorporated into the charging plan. When the battery 14 is forcibly charged, enough capacity for warm-keeping charging may be secured. The charging process for keeping the battery warm may be carried out either for the entire duration from the completion of charging to the start of takeoff or for only part of that time, as long as the battery temperature can be maintained within the aforementioned temperature range.

In adjustment of the charging start timing, if the battery is being forcibly cooled simultaneously with rapid charging, the charging start timing may be delayed to shorten the period between the completion of charging and takeoff. This makes it possible to prevent the temperature of the battery 14 from becoming too low or too high due to environmental influences. It is preferable to resolve any issues solely through the setting of the charging start timing. However, the charging start timing may be set after determination whether adjustment of the charging start timing is possible taking into account the operation plan of the aircraft. The operation plan includes the usage schedules of the charging device 50 and the temperature adjustment device 60.

After the conditions are set, the controller 40 then sets a charging plan (step S215) and proceeds to the process of step S30. Step S215 is a process corresponding to step S205. When T0 is between Tth2 and Tth3 in step S212, the controller 40 sets conditions for normal operation (step S216), and sets a charging plan based on the set conditions (S205). Step S216 is a process corresponding to step S206. Other configurations are similar to those described in the preceding embodiment.

### Summary of Second Embodiment

The controller 40 of the present embodiment determines whether to perform temperature adjustment of the battery 14 and/or perform adjustment of the start timing of charging of the battery 14 as a necessary process, based on the prediction of the pre-takeoff temperature T0. The controller 40 sets a charging plan for when the aircraft is parked based on the determination result. This makes it possible to reduce occurrence of battery abnormalities due to changes in battery temperature caused by environmental conditions during the period from the completion of charging to the start of takeoff. For example, it is possible to reduce the temperature drop of the battery 14, which is caused by environmental conditions and can lead to low-temperature abnormalities. For example, it is possible to reduce the temperature rise of the battery 14, which is caused by environmental conditions and can lead to high-temperature abnormalities during the next flight.

The controller 40 may include self-heating of the battery 14 due to charging during parking as part of the temperature adjustment process. By utilizing the self-heating for keeping the battery warm, it is possible to reduce the occurrence of low-temperature anomalies even when the temperature adjustment device 60 is not provided or when the temperature adjustment device 60 does not have sufficient warming capacity.

The controller 40 may predict the pre-takeoff temperature T0 based on the predicted battery temperature at the time of completion of charging, environmental information, and an operation plan of the aircraft. By taking into account the environmental temperature and the operation plan, the accuracy of predicting the pre-takeoff temperature T0 can be improved.

The configuration described in this embodiment can be combined with any of the preceding configurations. For example, in the charging plan setting process in step S20, both the plan setting process based on the prediction of the maximum temperature Tmax shown in FIG. 5 and the plan setting process based on the prediction of the pre-takeoff temperature T0 shown in FIG. 6 may be executed.

### Third Embodiment

This embodiment is a modification based on the preceding embodiments, and the description of the preceding embodiments are incorporated. In the preceding embodiment, the charging plan during parking is set based on the prediction of the maximum temperature Tmax during charging and the pre-takeoff temperature T0. Alternatively, or additionally, the charging plan during parking may be set based on a prediction of battery resistance at the time of charging completion.

A controller 40 of the present embodiment includes an acquisition unit 41 and a setting unit 42, similar to the preceding embodiments. The controller 40 may further include a control unit 43. The setting unit 42 sets a charging plan for when the aircraft is parked based on the profile acquired by the acquisition unit 41. The setting unit 42 may predict the battery resistance R at the time of charging completion as the battery state, and thus the degree of temporary deterioration of the battery 14, and based on this prediction result, it may detect signs of performance anomalies in the battery 14 during takeoff or flight. The setting unit 42 may determine, based on the prediction of the battery resistance R, whether to reduce the battery resistance as the necessary process, and specifically, whether to recover from the temporary deterioration. The determination by the setting unit 42 whether to reduce the battery resistance may be determination whether to charge and discharge the battery 14. The setting unit 42 may predict the battery resistance R at the time of completion of charging based on the battery resistance after landing and the rapid charging conditions.

### (Temporary Deterioration)

When the battery outputs (discharges) or inputs (charges), a temporary imbalance occurs in the concentration distribution of ions that contribute to the battery reaction. The concentration imbalance occurs in the electrolytic solution or the electrode. The concentration shifts in opposite directions during discharge and charge. When a concentration imbalance occurs, the degree of reversible temporary deterioration of the battery increases, meaning the battery resistance (internal resistance) rises. Therefore, even when the SOC of is sufficient, the input/output performance of the battery decreases. In particular, the degree of temporary deterioration increases with high output or continuous output, as well as with high input or continuous input. The temporary deterioration may be referred to as high-rate deterioration.

In an electric flight vehicle, especially eVTOLs, high output is required during takeoff flight and landing flight. Furthermore, continuous output is maintained during flight, making it more prone to an increase in the degree of temporary deterioration. If the degree of temporary deterioration increases, it could affect the high-power characteristics required for takeoff and landing, reducing the safety of the aircraft. In addition, temporary deterioration may occur simultaneously in multiple batteries, raising concerns that redundancy of the drive equipment may not be ensured.

On the other hand, during charging (high input) while the aircraft is parked, the ion concentration imbalance acts in the opposite direction compared to during output. In other words, it acts in a direction that alleviates the degree of temporary deterioration experienced during flight. Depending on the input/output profile during flight and the input profile during charging, the degree of temporary deterioration after charging (before takeoff) ultimately varies. For example, there is a risk that the temporary deterioration incurred during flight may not be fully alleviated, resulting in an accumulation of the degree of temporary deterioration. For example, there is a risk that high-input charging could reverse the concentration imbalance, leading to an increase in the degree of temporary deterioration. In any case, this could affect the output performance during takeoff and landing in the next flight, or the degree of temporary deterioration could accumulate over multiple flights, increasing the risk of performance abnormalities.

The temporary deterioration of the battery is not permanent abnormality or deterioration that cannot be recovered, such as disconnection abnormality or battery capacity deterioration, but is temporary deterioration that can be resolved. Therefore, it is desired to resolve or reduce the temporary deterioration during parking in advance.

### (How to Recover from Temporary Deterioration)

To reduce or resolve discharge-induced temporary deterioration that occurs during flight, the battery may be charged temporarily. Charging changes the direction of the current, which can forcibly reduce concentration imbalances. In other words, the degree of temporary deterioration can be reduced or resolved. For example, to reduce or resolve the charge-induced temporary deterioration that occurs during charging, the battery may be temporarily discharged. Discharging changes the direction of the current, which can forcibly reduce the concentration imbalances.

When addressing both discharge-induced and charge-induced temporary deterioration, charging may be temporarily stopped to reduce the charging current. By stopping the charging process, ion diffusion progresses, which reduces concentration imbalances. Therefore, the degree of temporary deterioration can be reduced. Since the progression of concentration imbalances depends on the charging current, reducing the charging current can suppress the progression of these imbalances. However, compared to temporary charging during discharge or temporary discharging during charging, resolving temporary deterioration takes more time.

When addressing both discharge-induced and charge-induced temporary deterioration, temporary charge and discharge cycles may be performed Concentration imbalances can be forcibly resolved by applying an alternating current or performing temporary charge and discharge cycles with a small ΔSOC. A pulsating current, such as a ripple current, may also be applied. Repeated charging and discharging using a rectangular wave or similar waveform may also be employed. Discharging may be performed using an external charge and discharge device or a discharge device, or achieved by the battery output to the EPU 15 or auxiliary equipment. To prevent further temporary deterioration, it is advisable to perform the process when the battery is nearly fully charged.

Temporary charge and discharge processing can efficiently resolve both discharge-induced temporary deterioration and charge-induced temporary deterioration. If the predicted increase in battery resistance at the time of full charge, i.e., the degree of temporary deterioration, exceeds a predetermined value, it may be determined that charge and discharge processing is necessary as a process to reduce battery resistance. The increase in resistance (degree of temporary deterioration) is the difference (ΔR) from the reference value of the internal resistance. The degree of temporary deterioration may be defined as the increase in resistance from the value measured after the previous temporary deterioration was resolved. The threshold value can be set with a margin added to an upper limit resistance value, which is determined to ensure no performance abnormality occur even under the worst-case scenario of increased temporary deterioration during the next flight. The margin can be set by considering various errors such as the prediction error of battery resistance due to flight, control errors of charging and discharging equipment, and other detection and operational errors. The charge and discharge processing may also be incorporated at the completion of charging using predetermined charge and discharge conditions. The charge and discharge conditions may be determined in advance through experiments, based on the degree of temporary deterioration.

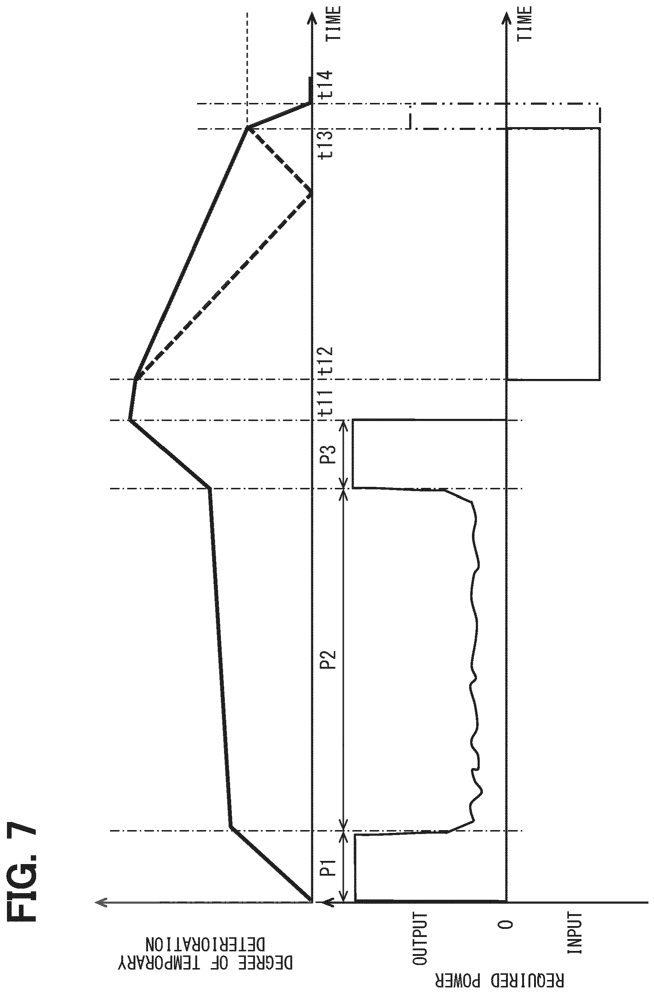

FIG. 7 is a diagram illustrating an example of a change in degree of temporary deterioration due to flight and charging after the flight. FIG. 7 shows an example of resolving the temporary deterioration due to charging and discharging. As described above, the eVTOL 10 requires high output during period P1 (during takeoff flight) and period P3 (during landing flight). Furthermore, the output is continuous during flight, and the degree of temporary deterioration is likely to increase even during period P2 (cruising flight). Therefore, at time t11 when landing is completed, the degree of temporary deterioration has increased significantly compared to when takeoff began.

When charging during parking begins at time t12 after a predetermined time from t11, the concentration imbalance caused by discharge during flight is resolved, and the degree of temporary deterioration is reduced. In the period from time t12 to time t13, the solid line indicates a case where temporary deterioration cannot be completely resolved by charging. The dashed line indicates a case where the concentration imbalance is reversed by charging. After time t13, charging and discharging are performed as appropriate, and the degree of temporary deterioration is resolved at time t14. In FIG. 7, charging and discharging after time t13 is indicated by a two-dot chain line.

### (Control Method)

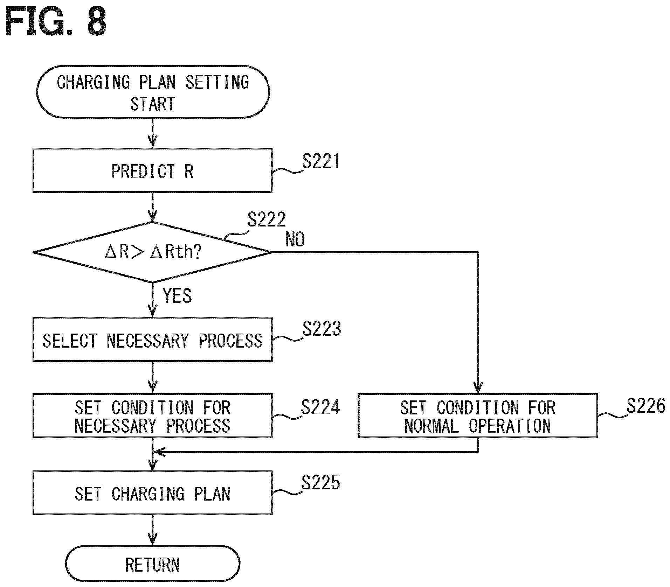

FIG. 8 shows the process of step S20 among the control processes executed by the controller 40 (processor). The processes shown in FIG. 8 correspond to the processes shown in FIG. 5. First, the controller 40 predicts the resistance R of the battery 14 at the completion of charging based on the profile acquired in step S10 (step S221). Step S221 is a process corresponding to step S201. The controller 40 may predict the degree of temporary deterioration ΔR based on the resistance R.

The controller 40 may predict the battery resistance at the start of charging based on the profile during landing flight, and predict the battery resistance at the completion of charging based on the resistance at the start and the charging conditions. The controller 40 may predict the degree of temporary deterioration at the start of charging, and predict the degree of temporary deterioration at the completion of charging based on the predicted degree at the start and charging information. In addition, the battery resistance or the degree of or temporary deterioration after landing may also be predicted. The start of charging is also an example of a timing after landing. Immediately after landing, the battery resistance or the degree of deterioration may be predicted. The battery resistance or the degree of deterioration may be predicted before charging begins and after a predetermined time has elapsed since landing.

The resistance or the degree of deterioration at the start of charging is predicted based on the battery power load profile during landing flight and/or the battery resistance or battery voltage variation profile during landing flight. The resistance or the degree of temporary deterioration at the completion of charging is predicted based on the power profile, which is the charging condition during charging. The controller 40 may perform the prediction regarding the start of charging and the prediction regarding the completion of charging consecutively, or may perform them with a predetermined time interval therebetween. The controller 40 may directly predict the resistance R at the completion of charging or the degree of temporary deterioration ΔR at the completion of charging based on the power load profile of the battery 14 during landing flight and/or the battery resistance variation profile during landing flight and the power profile that is the charging condition. Instead of the battery resistance variation profile during landing flight, the battery voltage variation profile during landing flight may be used. Specifically, the controller 40 may directly predict the resistance R at the completion of charging or the degree of temporary deterioration ΔR at the completion of charging based on the power load profile of the battery 14 during landing flight and/or the battery voltage variation profile during landing flight and the power profile that is the charging condition.

As described above, the controller 40 may predict the resistance R, and thus the degree of temporary deterioration ΔR, using the power load profile of the battery 14 during landing flight. The battery resistance at the start of charging may be predicted using a map model or a regression model that associates the profile itself or a feature quantity obtained from the profile with the battery resistance at the start of charging. The feature quantity is, for example, a current integrated value. Machine learning can be used to efficiently build feature quantities and models. The current integrated value may be calculated taking into account the current during standby on the ground. When the battery current is zero during standby, the integrated value may be corrected in a direction that resolves the concentration imbalance. The correction value may be calculated using a map or a regression model created in advance from data such as an experiment.

The larger the battery current (higher output) or the longer the output duration, the more likely the concentration imbalance is to occur. Therefore, when using the integrated value of current, it may be integrated with weighting applied to each battery current value and/or duration. The weighting coefficient may be calculated using a map or a regression model created in advance from data such as an experiment.

Furthermore, a battery reaction simulation model that derives the battery resistance at the start of charging by inputting the profile itself or its feature quantities may also be used. It is possible to make predictions with greater accuracy. The battery reaction simulation model is a battery reaction model capable of analyzing the temporary concentration imbalances of ions.

The controller 40 may predict the resistance R at the completion of charging, and thus the degree of temporary deterioration ΔR, using a method similar to that used for predicting the resistance at the start of charging. For example, a map model, a regression model, a battery reaction simulation model, or the like that associates the battery resistance at the start of charging, the charging conditions, and the battery resistance at the completion of charging may be used.

The controller 40 may directly predict the resistance R at the completion of charging, and thus the degree of temporary deterioration ΔR, using a method similar to that for predicting the resistance at the start of charging. A map model, a regression model, a battery reaction simulation model, or the like that associates the profile itself or feature quantities obtained from the profile with the charging conditions and the battery resistance at the end of charging can be used.

When predicting the resistance R and the degree of temporary deterioration ΔR using the power load profile during landing flight, it is necessary to obtain information on the absolute value of the battery resistance at any timing in the profile. The absolute value of the battery resistance may be an actually measured value or an estimated value.

The training data required for the above-mentioned modeling and the various parameters required for the battery reaction simulation may be extracted from prior experiments, flight history, etc. When predicting the resistance at the start of charging, it is preferable to construct a model that allows the battery resistance to be predicted even if the charge start time point is changed. For example, input information (explanatory variables) to the model may include battery temperature, environmental temperature, etc. The prediction can be made more accurate. Information for the prediction may include Input/output profiles from the takeoff flight.

As described above, the controller 40 may predict the resistance R, and therefore the degree of temporary deterioration ΔR, using the battery resistance or battery voltage variation profile during landing flight. Alternatively, a map model or a regression model that associates the profile itself or a feature quantity obtained from the profile with the battery resistance at the start of charging may be used for the prediction. The feature quantity is a relaxation constant of the battery resistance or the battery voltage, the battery resistance or the battery voltage at a specific point in time, the rate of change of the battery resistance or battery voltage at a specific point in time, or a combination thereof. The variation profile of the battery resistance or battery voltage may include intermediate information on transient changes after landing. This makes it possible to reflect the variation state of the battery resistance or battery voltage from the maximum state of concentration imbalance that accompanies landing, thereby improving the accuracy of predictions.

The training data required for the above-mentioned modeling may be extracted from prior experiments, flight history, etc. The input information (explanatory variables) to the model may include battery temperature, environmental temperature, etc. The prediction can be made more accurate. It is preferable to construct a model that allows the battery resistance to be predicted even if the charge start point is changed.

After predicting the resistance R at the end of charging, the controller 40 then compares the degree of temporary deterioration ΔR at the end of charging with a threshold ΔRth, and determines whether the degree of temporary deterioration ΔR is greater than the threshold Rth (step S222). When ΔR is greater than ΔRth, the controller 40 detects a sign of abnormality in battery performance during takeoff or flight. When ΔR is lower than or equal to ΔRth, the controller 40 determines that there is no sign of an abnormality in battery performance.

The process of step S222 is a process for determining whether to perform a necessary process based on the result of prediction of resistance R (degree of temporary deterioration ΔR). Step S222 is a process corresponding to step S202. When the predicted degree of temporary deterioration ΔR exceeds a threshold ΔRth, temporary charging and discharging is determined to be necessary as a process for reducing or resolving the temporary deterioration. As described above, the threshold ΔRth may be set by adding a margin to the upper limit resistance value at which no performance abnormality occurs even under the worst-case scenario of increased temporary deterioration during the next flight.

When ΔR is greater than ΔRth, the controller 40 selects a necessary process (step S223). Step S223 is a process corresponding to step S203. The controller 40 selects, as the necessary process, a process for reducing the battery resistance, that is, a process for reducing the degree of temporary deterioration. The process for reducing the battery resistance includes a charge and discharge processing.

After the necessary process is selected, the controller 40 then sets the conditions for the necessary process (step S224). Step S224 is a process corresponding to step S204. The controller 40 sets the charging conditions (charge and discharge conditions) of the battery 14 so that the degree of temporary deterioration becomes equal to or lower than a predetermined value at the completion of rapid charging. The controller 40 may set the charge and discharge conditions so that the degree of temporary deterioration becomes zero at the completion of rapid charging.

After the conditions are set, the controller 40 then sets a charging plan (step S225). The controller 40 sets a profile for charging and discharging the battery 14 based on the necessary process and its conditions. When the controller 40 sets the charging plan, the series of processes ends. That is, the process proceeds to step S30.

When ΔR is lower than or equal to ΔRth in step S222, the controller 40 sets conditions for normal operation (step S226), and sets a charging plan based on the set conditions (S225). The normal operating conditions are rapid charging conditions that do not take into account the reduction in battery resistance. Other configurations are similar to those described in the preceding embodiment.

### Summary of Third Embodiment

The controller 40 of the present embodiment determines whether to perform a process for reducing the battery resistance as the necessary process, based on a prediction of the resistance R of the battery 14 at the completion of charging, i.e., the degree of temporary deterioration ΔR. The controller 40 sets a charging plan for when the aircraft is parked based on the determination result. Temporary deterioration occurs due to the high output load during flight and the high input load during charging. Any abnormality signs caused by this temporary deterioration can be resolved when the aircraft is parked.

The controller 40 may include a charge and discharge process as a process for reducing the battery resistance. This makes it possible to efficiently resolve temporary deterioration within the charging profile (charge and discharge profile) while the aircraft is parked.

The controller 40 may predict the battery resistance R at the completion of charging based on the battery resistance before charging starts (after landing) and the rapid charging conditions. The degree of temporary deterioration caused by the high output load during flight can be predicted, and changes in the degree of temporary deterioration caused by charging during parking can also be predicted. This improves the accuracy of predicting the battery resistance R, and makes it possible to efficiently resolve temporary deterioration.

The configuration described in this embodiment can be combined with any of the preceding configurations. For example, in the charging plan setting process in step S20, the plan setting process based on the prediction of the battery resistance R (degree of temporary deterioration ΔR) may be combined with the plan setting processes described in the preceding embodiments. As the charging plan setting process, the controller 40 may execute at least one of a plan setting process based on the prediction of the battery resistance R, a plan setting process based on the prediction of the maximum temperature Tmax, and a plan setting process based on the prediction of the pre-takeoff temperature T0.

### Fourth Embodiment

This embodiment is a modification based on the preceding embodiments, and the description of the preceding embodiments are incorporated. In the previous embodiment, the necessary process includes temperature adjustment of the battery 14 and/or change of the charging conditions. Alternatively, or additionally, the necessary process includes a battery check before the start of charging.

A controller 40 of the present embodiment includes an acquisition unit 41 and a setting unit 42, similar to the preceding embodiments. The controller 40 may further include a control unit 43. The setting unit 42 sets a charging plan for when the aircraft is parked based on the profile acquired by the acquisition unit 41. The setting unit 42 may detect other abnormal signs in addition to the abnormal signs shown in the preceding embodiments based on the battery state profile during landing flight. Other abnormality signs include, for example, insulation abnormality, short circuit abnormality, overcurrent abnormality, monitoring abnormality, cooling abnormality, and communication abnormality. The setting unit 42 can detect such other signs of abnormality by detecting unexpected variation based on the battery state profile during landing flight. When an unexpected variation is detected, the setting unit 42 may perform a battery check before the start of charging as the necessary process that needs to be performed in relation to charging while the aircraft is parked.

Unexpected variation in various battery states may be extracted by comparison between batteries (between battery packs) or within a battery (between battery cells or battery modules). Unexpected variation may be extracted by comparing with past historical data and comparing variation over time. A predetermined threshold may be used to determine whether a variation is unexpected.

A profile after landing and before the completion of the battery transient change may be used, instead of or in addition to the profile during landing flight. This addition can reduce the probability of overlooking abnormality signs generated at the time of landing.

### (Control Method)

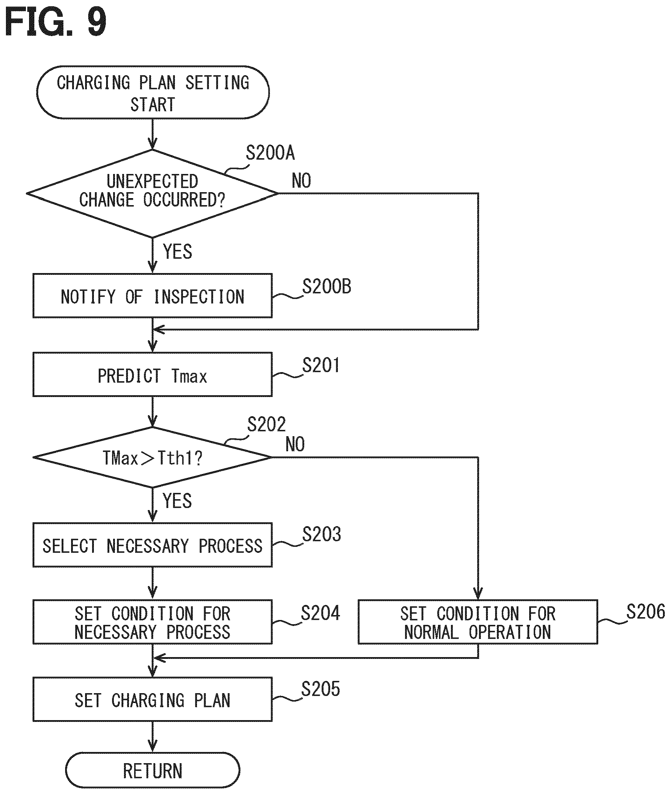

FIG. 9 shows the process of step S20 among the control processes executed by the controller 40 (processor). The processes shown in FIG. 9 correspond to the processes shown in FIG. 5. The processes shown in FIG. 9 are the same as the processes shown in FIG. 5 except for additional steps S200A and S200B.

First, the controller 40 determines whether an unexpected change has occurred in the battery state related to the other abnormality signs described above, based on the battery state profile acquired in step S10 (step S200A). Step S200A is a process for determining whether the necessary process is required. When an unexpected variation is detected, the controller 40 notifies the implementation of a battery inspection (step S200B). Upon receiving the notification, an inspection of the battery 14 is performed. The inspection of the battery before the start of charging may include tasks such as battery replacement or repair. The inspection of the battery 14 may be performed by an operator upon receiving the notification, or by an inspection device upon receiving the notification.

When the battery inspection is completed, that is, when other abnormality signs have been reduced or resolved as a result of the inspection, the controller 40 executes the processes from step S201 onwards, as in the preceding embodiments. In step S200A, when it is determined that no unexpected variation has occurred, that is, that the necessary process is unnecessary, the processes from step S201 onward are executed without performing the processing of step S200B.

The execution timing of steps S200A and S200B is not limited to the example shown in FIG. 9. For example, it may be executed after steps S204 and S206 and before step S205. This may be performed after step S205. It is sufficient to execute this after step S10 and before step S30. Other configurations are similar to those described in the preceding embodiment.

### Summary of Fourth Embodiment

The controller 40 of the present embodiment determines the necessity of a battery inspection before starting the charging as the necessary process, based on the battery status profile during landing flight. Accordingly, it is possible to check for signs of battery abnormalities through inspection before rapid charging, which imposes a high input load. Thus, the safety of the flight can be enhanced.

The configuration described in this embodiment can be combined with any of the preceding configurations. Although a combination with the charging plan setting based on the prediction of the maximum temperature Tmax has been shown, it is not limited to this. It may also be combined with the charging plan setting based on the prediction of the battery temperature T0 just before takeoff. It may also be combined with the charging plan setting based on the prediction of the battery resistance R (degree of temporary deterioration ΔR) at the time of charging completion. It may be used alone without being combined with the preceding embodiments. For example, in FIG. 9, the processes of steps S201, S202, S203, and S204 may be omitted.

### Other Embodiments

The disclosure in this specification, the drawings, and the like is not limited to the exemplified embodiments. The disclosure includes exemplary embodiments and modifications by those skilled in the art based on the exemplary embodiments. For example, the disclosure is not limited to the combinations of components and/or elements shown in the embodiments. The disclosure may be implemented in various combinations. The disclosure may include additional portions that can be added to the embodiments. The disclosure includes those in which the components and/or elements of the embodiments are omitted. The disclosure includes the replacement or combination of components and/or elements between one embodiment and another embodiment. The disclosed technical scope is not limited to the description of the embodiments. The several technical scopes disclosed are indicated by the description of the claims, and should be further understood to include meanings equivalent to the description of the claims and all modifications within the scope.

The disclosure in the specification, drawings and the like are not limited by the description of the claims. The disclosures in the specification, the drawings, and the like encompass the technical ideas described in the claims, and further extend to a wider variety of technical ideas than those in the claims. Hence, various technical ideas can be extracted from the disclosure of the specification, the drawings, and the like without being bound by the description of the claims.

When an element or layer is referred to as being "on," "coupled," "connected," or "combined," it may be directly on, coupled, connected, or combined to the other element or layer, or further, intervening elements or layers may be present. In contrast, when an element or a layer is described as "disposed directly above" or "directly connected", an intervening element or an intervening layer is not present. Other terms used to describe the relationships between elements (for example, "between" vs. "directly between", and "adjacent" vs. "directly adjacent") should be interpreted similarly. As used herein, the term "and/or" includes any combination and all combinations relating to one or more of the related listed items. For example, the term A and/or B includes only A, only B, or both A and B.

Each of the various flowcharts shown in the present disclosure is an example, and the number of steps constituting the flowchart and the execution order of the process can be appropriately changed. The device, the system and the method therefor described in the present disclosure may be implemented by a dedicated computer which constitutes a processor programmed to perform one or more functions by executing computer programs. The device and the method described in the present disclosure may be also implemented by a dedicated hardware logic circuit. Furthermore, the device and the method thereof described in the present disclosure may be implemented by one or more special purpose computers formed by a combination of a processor that executes computer programs and one or more hardware logic circuits.

For example, a part or all of the functions of the processor 311 may be realized as hardware. An aspect in which a certain function is implemented as hardware includes an aspect in which one or multiple ICs are used. As the processor (arithmetic core), a CPU, MPU, GPU, DFP, or the like can be adopted. CPU is an abbreviation for Central Processing Unit. MPU is an abbreviation for Micro-Processing Unit. GPU is an abbreviation for Graphics Processing Unit. DFP is an abbreviation for Data Flow Processor.

A part or all of the functions of the processor 311 may be realized by combining multiple types of arithmetic processing devices. A part or all of the functions of the processor 311 may be implemented using an SoC, ASIC, FPGA, or the like. SoC is an abbreviation for System-on Chip. ASIC is an abbreviation for Application Specific Integrated Circuit. FPGA is an abbreviation for Field-Programmable Gate Array. The same applies to the processor 201.

The computer program described above may be stored in a computer-readable non-transitory tangible storage medium as instructions to be executed by a computer. As the program storage medium, an HDD, an SSD, a flash memory, or the like can be adopted. HDD is an abbreviation for Hard-Disk Drive. SSD is an abbreviation for Solid State Drive. The scope of the present disclosure also includes a program causing a computer to function as the controller or the control system, and forms such as a non-transitory tangible storage medium such as a semiconductor memory in which the program is stored.

### Disclosure of Technical Ideas

This description discloses multiple technical ideas described in multiple sections listed below. Some sections may be presented in multiple dependent form in which a subsequent section refers to the preceding sections selectively. Moreover, some sections may be written in multiple dependent form referring to another multiple dependent form. These sections written in the multiple dependent form define multiple technical ideas.

### Technical Idea 1

A controller for controlling charging of a battery (14) mounted on an electric flight vehicle (10). The controller includes an acquisition unit and a setting unit. The acquisition unit (41) is configured to acquire a battery profile, the battery profile including a battery load profile during landing flight and/or a battery state profile during landing flight. The setting unit (42) is configured to set a charging plan based on the battery profile before completion of a transient change of the battery after landing, the charging plan being a plan of charging during parking of the vehicle.

### Technical Idea 2

In the controller according to technical idea 1, the setting unit is configured to perform necessity determination whether temperature adjustment of the battery and/or change of a charging condition of the battery is necessary as a necessary process for charging during parking of the vehicle. The setting unit is configured to set the charging plan based on a result of the necessity determination.

### Technical Idea 3

In the controller according to technical idea 2, the setting unit is configured to perform the necessity determination whether forced cooling of the battery before start of charging and/or limitation on charging power at start of charging is necessary as the necessary process, based on a prediction of maximum temperature of the battery during charging while the vehicle is parked.

### Technical Idea 4

In the controller according to technical idea 3, the setting unit is configured to predict the maximum temperature under a condition that results in a minimum charging power among charging conditions that satisfy a required charging capacity and an operation plan of the vehicle.

### Technical Idea 5

In the controller according to any one of technical ideas 2 to 4, the setting unit is configured to perform the necessity determination whether the temperature adjustment of the battery and/or adjustment of a start timing of charging the battery is necessary as the necessary process, based on a prediction of a battery temperature before takeoff.

### Technical Idea 6

In the controller according to technical idea 5, the temperature adjustment of the battery includes self-heating of the battery due to charging while the vehicle is parked.

### Technical Idea 7

In the controller according to technical idea 5 or 6, the setting unit is configured to predict the battery temperature before takeoff based on a predicted battery temperature at completion of charging, environmental information, and an operation plan of the vehicle.

### Technical Idea 8

In the controller according to any one of technical ideas 2 to 7, the setting unit is configured to perform the necessity determination whether reduction of a resistance of the battery is necessary as the necessary process, based on a prediction of a battery resistance at completion of charging.

### Technical Idea 9

In the controller according to technical idea 8, the reduction of the resistance of the battery includes charge and discharge processing of the battery.

### Technical Idea 10

In the controller according to technical idea 8 or 9, the setting unit is configured to predict the battery resistance at completion of charging based on a battery resistance at start of charging and a rapid charging condition.

### Technical Idea 11

In the controller according to any one of technical ideas 2 to 10, the setting unit is configured to perform the necessary determination whether a battery inspection before start of charging is necessary as the necessary process, based on the battery state profile during landing flight.

## Claims

1. A controller for controlling charging of a battery (14) mounted on an electric flight vehicle (10), the controller comprising:
an acquisition unit (41) configured to acquire a battery profile, the battery profile including a battery load profile during landing flight and/or a battery state profile during landing flight; and
a setting unit (42) configured to set a charging plan based on the battery profile before completion of a transient change of the battery after landing, the charging plan being a plan of charging during parking of the vehicle.

2. The controller according to claim 1, wherein
the setting unit is configured to
perform necessity determination whether temperature adjustment of the battery and/or change of a charging condition of the battery is necessary as a necessary process for charging during parking of the vehicle, and
set the charging plan based on a result of the necessity determination.

3. The controller according to claim 2, wherein
the setting unit is configured to perform the necessity determination whether forced cooling of the battery before start of charging and/or limitation on charging power at start of charging is necessary as the necessary process, based on a prediction of maximum temperature of the battery during charging while the vehicle is parked.

4. The controller according to claim 3, wherein
the setting unit is configured to predict the maximum temperature under a condition that results in a minimum charging power among charging conditions that satisfy a required charging capacity and an operation plan of the vehicle.

5. The controller according to claim 2, wherein
the setting unit is configured to perform the necessity determination whether the temperature adjustment of the battery and/or adjustment of a start timing of charging the battery is necessary as the necessary process, based on a prediction of a battery temperature before takeoff.

6. The controller according to claim 5, wherein
the temperature adjustment of the battery includes self-heating of the battery due to charging while the vehicle is parked.

7. The controller according to claim 5 or 6, wherein
the setting unit is configured to predict the battery temperature before takeoff based on a predicted battery temperature at completion of charging, environmental information, and an operation plan of the vehicle.

8. The controller according to claim 2, wherein
the setting unit is configured to perform the necessity determination whether reduction of a resistance of the battery is necessary as the necessary process, based on a prediction of a battery resistance at completion of charging.

9. The controller according to claim 8, wherein
the reduction of the resistance of the battery includes charge and discharge processing of the battery.

10. The controller according to claim 8 or 9, wherein
the setting unit is configured to predict the battery resistance at completion of charging based on a battery resistance at start of charging and a rapid charging condition.

11. The controller according to claim 2, wherein
the setting unit is configured to perform the necessary determination whether a battery inspection before start of charging is necessary as the necessary process, based on the battery state profile during landing flight.

12. A control method executed by a processor (311) for controlling charging of a battery (14) mounted on an electric flight vehicle (10), the method comprising:
acquiring a battery profile, the battery profile including a battery load profile during landing flight and/or a battery state profile during landing flight; and
setting a charging plan based on the battery profile before completion of a transient change of the battery after landing, the charging plan being a plan of charging during parking of the vehicle.

13. A control program stored in a storage medium (313) for controlling charging of a battery (14) mounted on an electric flight vehicle (10), the control program including instructions configured, when executed by a processor (311), to cause the processor to carry out:
acquiring a battery profile, the battery profile including a battery load profile during landing flight and/or a battery state profile during landing flight; and
setting a charging plan based on the battery profile before completion of a transient change of the battery after landing, the charging plan being a plan of charging during parking of the vehicle.
